Europäisches Patentamt

European Patent Office

Office européen des brevets

(19)

(11) Publication number: **0 000 262**
**B1**

# EUROPEAN PATENT SPECIFICATION

(45) Date of publication of patent specification: **29.04.81**

(51) Int. Cl.³: **G 03 F 7/16**

(21) Application number: **78300062.3**

(22) Date of filing: **21.06.78**

(54) **Method of and spinning head for spin coating resist onto a wafer.**

(30) Priority: **30.06.77 US 811732**

(43) Date of publication of application:
**10.01.79 Bulletin 79/1**

(45) Publication of the grant of the European patent:
**29.04.81 Bulletin 81/17**

(84) Designated Contracting States:
**DE FR GB**

(56) References cited:
**IBM TECHNICAL DISCLOSURE BULLETIN, volume
16, number 6, November 1973, Armonk, New
York
R. P. ESCH et al. "Rheology control of films
deposited by spin coating techniques
*Pages 1730 and 1731***

**IBM TECHNICAL DISCLOSURE BULLETIN, volume
19, number 6, November 1976, Armonk, New
York
H. WETZ "Remover for peripheral resist build-
ups"
*Pages 2114—2115***

(73) Proprietor: **International Business Machines
Corporation
Armonk, N.Y. 10504 (US)**

(72) Inventor: **Canavello, Benjamin John
17 Brewster Avenue
Stoney Point New York 10980 (US)**
Inventor: **Hatzakis, Michael
21 Collyer Drive
Ossining New York 10562 (US)**
Inventor: **Siegel, Arthur Richard
2786 Springhurst St.
Yorktown Heights New York 10598 (US)**
Inventor: **Watters, Connell
100 Castle Court
Yorktown Heights New York 10598 (US)**

(74) Representative: **Blakemore, Frederick N.
IBM United Kingdom Patent Operations Hursley
Park
Winchester Hants, SO21 2JN (GB)**

## Method of and spinning head for spin coating resist onto a wafer

The present invention relates to a method of spin coating resist onto a wafer. The invention also relates to a spinning head for spin coating resist onto a wafer.

In known techniques employed to spin coat a resist onto a wafer by means of a spinning head, the wafers are baked after having been spin coated and are subsequently exposed to ultraviolet radiation to clear an outer ring around the edge of the wafer. After development the resist is removed and the ring is used to make electrical contact for electroplating. The provision of the outer ring has required exposure and development steps.

In addition, it has been observed that in spin coating a resist onto a wafer there is an unwanted build-up of resist at the edge of the wafer especially when thick resist solutions are cast onto the wafer.

It has already been proposed in the IBM Technical Disclosure Bulletin, Vol. 16, No. 6, pages 1730 and 1731, to provide a more uniform thickness of resist by controlling the rate of resist evaporation during spinning.

It has also been proposed in the IBM Technical Disclosure Bulletin, Vol. 19, No. 6, pages 2114 and 2115, to avoid an unwanted build-up of resist at the edge of a wafer by blowing off the peripheral resist build-up by means of suitably directed jets.

The present invention now provides a method of spin coating resist onto a wafer, the method incorporating the steps of mounting the wafer onto a rotatable wafer platform, spinning the wafer by means of the platform and applying the resist onto the wafer. In order to provide an area of the wafer clear of the resist, the method is characterised in that the wafer is clamped onto the platform by means of a plate which is tapered into a knife edge at the wafer surface to seal the top of the wafer in contact with the plate and to allow the resist to flow up over the clamping plate and off the spinning head.

The invention also provides a spinning head for spin coating resist onto a wafer, the head incorporating a base to be driven by a spin motor shaft, and a wafer platform mounted on the base to receive a wafer to be spin coated characterised in that the wafer platform has a clamp plate to clamp a wafer to be coated onto the platform, the clamp plate having a flat lower surface to engage and seal off a portion of a wafer to be coated and an upper surface tapered to meet the lower surface at a knife edge to allow resist to flow up over the clamp plate and off the head.

The clamp plate is preferably of circular ring configuration. Preferably, the clamp plate has means for attachment to the base and the wafer platform is supported by a spring and ball joint interposed between the wafer platform and the base to enable the wafer platform to be depressed and to swivel relative to the base to accommodate a wafer between the clamp plate and the wafer platform.

The invention will now be further described by way of example with reference to the drawings in which:—

FIGURE 1 shows an assembled wafer spinning head embodying the present invention;

FIGURE 2 shows a sectional exploded view of the head of Figure 1;

FIGURE 3 shows a spring and ball support sub-assembly included in the head of Figure 1;

FIGURE 4 shows an exploded view of the sub-assembly of Figure 3;

FIGURE 5 shows an exploded view of a ring spinner and bayonet lock ring sub-assembly included in the head of Figure 1; and

FIGURE 6 shows in plan a wafer after having been resist coated using the head of the previous Figures.

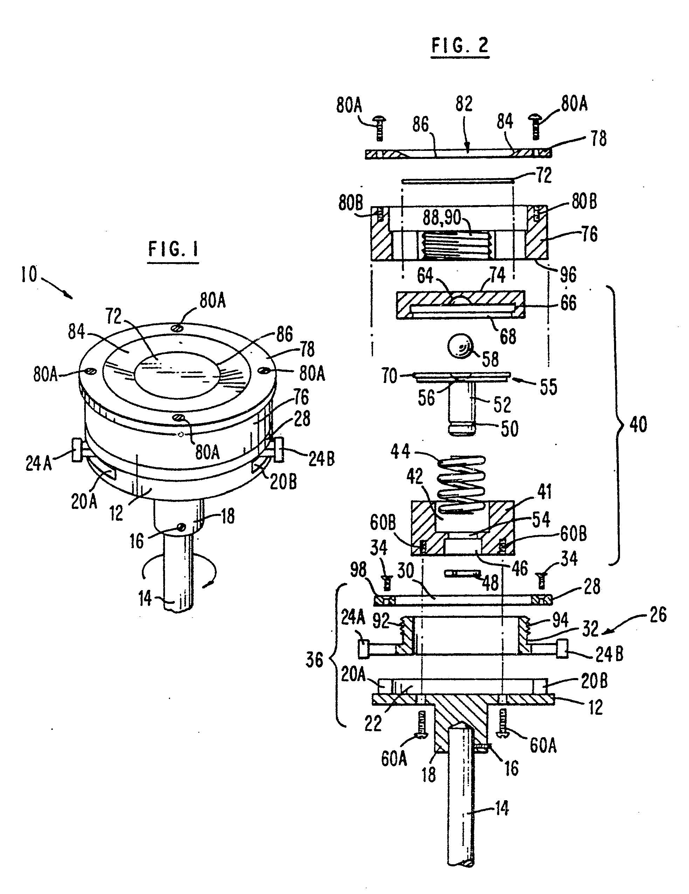

Referring to Figures 1 and 2, a wafer spinner chuck 10 includes a base 12 adapted to be attached to a spinner motor shaft 14, by a set screw 16 which holds the motor shaft 14 in place in the hub 18 of base 12.

Base 12 has a notched portion 20A and 20B on opposite sides of the raised shoulder portion 22 such that the arms 24A and 24B of a bayonet lock ring 26 cooperate in the respective notched portions 20A and 20B. A retainer ring 28 has a central opening 30 for accommodating the central portion 32 of the lock ring 26. During assembly, the retainer ring 28 is attached, such as by screw means 34, to the base 12 with the lock ring 26 interposed between such members 12 and 28 and the bayonet arms 24A and 24B extending through the slots formed by the notches 20A and 20B and the retainer ring 28. The base 12, ring 26 and retainer ring 28 co-operate to form a bayonet lock ring assembly 36.

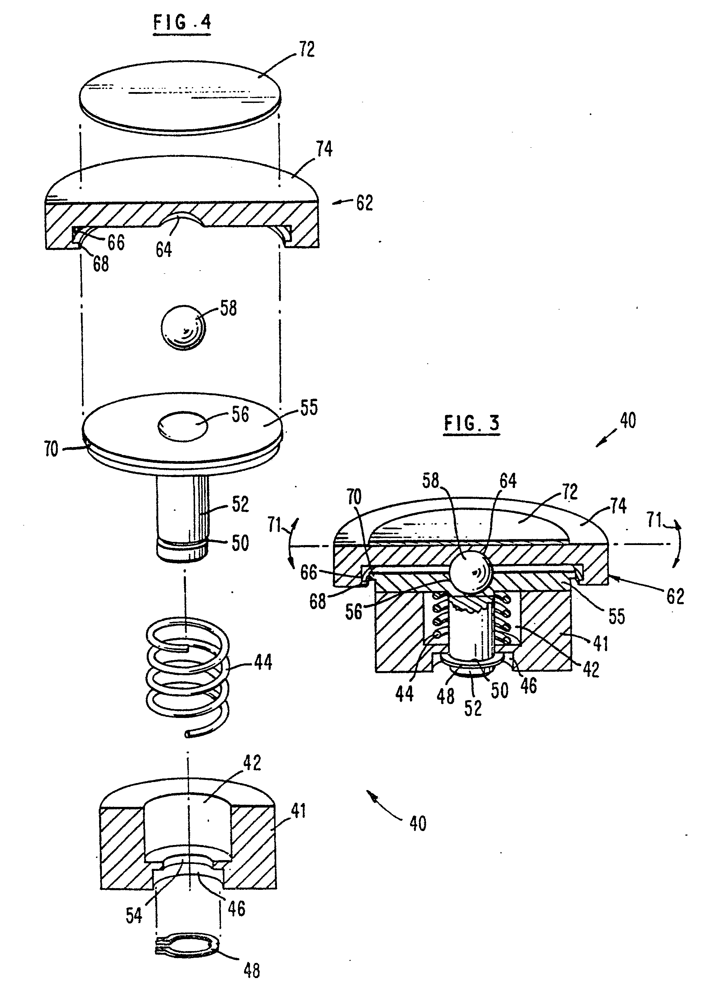

A spring mount and ball support sub-assembly 40 shown in further detain in Figures 3 and 4 includes a spring mounting cylinder 41 having a first recess 42 for retaining a spring 44, and a second recess 46 for accommodating a retainer ring lock 48 which embraces a groove 50 of a ball support shaft 52 that passes through spring 44, recess 42, an interconnecting passage 54, and into clearance recess 46 for retainer ring 48 installation. Passage 54 has a smaller diameter relative to the recesses 42 and 46 to secure the ball support shaft 52 such that the latter is spring loaded when secured by retainer ring 48. Attached to the ball support shaft 52 is a ball support platform 55 having a circular detent 56 for receiving a ball 58.

The spring mount and ball support subassembly 40 is connected to the base 12 by screws 60A and threaded holes 60B in the spring mounting cylinder 41. A wafer platform 62 is coupled to the ball support platform 55 via the ball 58 which rides in both its detent 56 and a matching detent 64 in the underside of wafer platform 62 as shown. The wafer platform 62 has a circular internal recess 66 at its underside with a shoulder 68 for receiving and retaining a rim 70 on the outer diameter of the ball support platform 55. The height of recess 66 is greater than the height of the rim 70 to permit a swivel action of wafer platform 62 relative to the ball support platform 55 as indicated by arrows 71 in Figure 3.

A wafer 72 is placed on the smooth polished surface 74 of the wafer platform 62. The spring mount and ball support sub-assembly 40 permits the wafer platform 62 to swivel and compress downward so that the knife-edge ring can conform to irregularities in the wafer surface, thus creating a seal, and accommodating wafers of various thicknesses. Also the spring mount and ball support sub-assembly maintains an alignment of the top wafer surface perpendicular to the spinning axis. The wafer 72 is held down by a ring spinner top 76 on which an interchangeable top plate 78 is mounted, such as by screw means 80A and 80B. The hole 82 in the centre of this top plate 78 determines the area of the wafer 72 on which resist will be coated. One feature of the wafer spinner chuck is that the inner edge of the top plate 78 is tapered as shown at 84 on the top side to a knife-edge 86 which seals the top of the wafer and does not allow any resist to flow under the plate. Instead, the resist is guided, during spinning by the tapered top surface 84 to the edge of the plate and off the head.

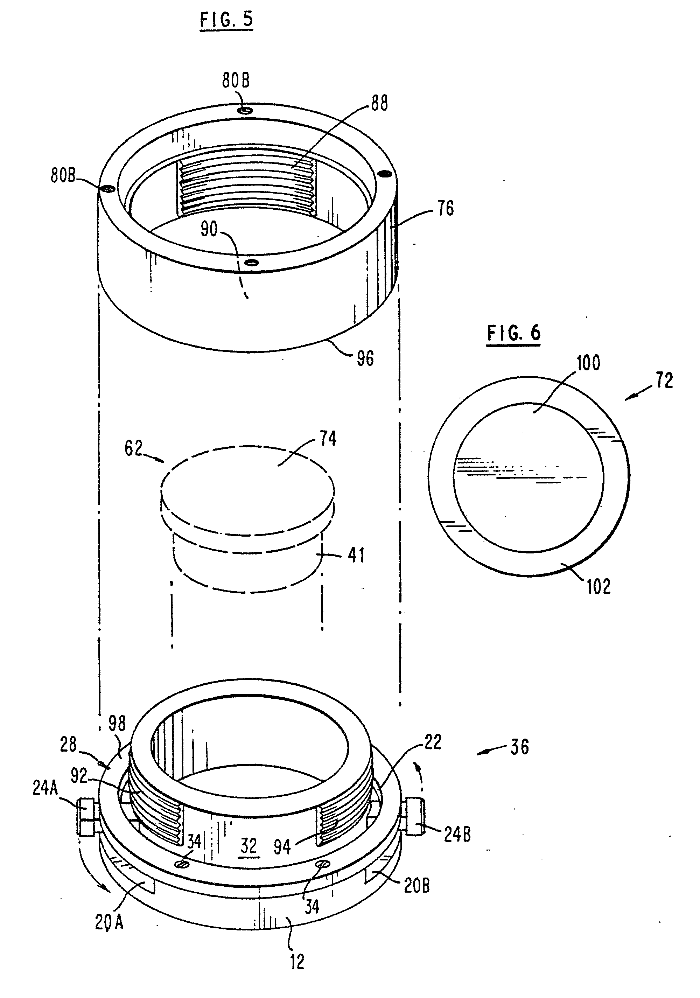

The manner of locking the ring spinner top 76 into the bayonet and lock ring assembly 36 is shown in Figure 5. Here, the ring spinner top 76 includes internal locking grooves or thread sectors 88 and 90 which respectively slide into and lock onto a pair of mating thread sectors 92 and 94 formed on the central portion 32 of the lock ring 26. The spinner top 76 is locked onto the base 12 via the bayonet and lock ring 26 by pressing the spinner top 76 down to compress the sub-assembly 40 through its spring 44 so the bottom surface 96 of spinner top 76 hits flush with the top surface 98 of the retainer ring 28. The bayonet and lock ring 26 is rotated by arms 24A and 24B, about 1/4 turn, to cause the spinner top threads 88 and 90 to engage with the lock ring threads 92 and 94. This action locks together the entire assembly with the wafer 72 compressed by the top 78 onto the wafer platform surface 74. The interchangeable top plate 78 allows the coating of different diameter wafers or different widths of the edge ring. It also allows for certain areas on the edge of the wafer, such as areas containing registration marks, to be protected from resist coating. This increases the signal-to-noise ratio obtained by electronically or optically scanning these marks during registration and therefore allows for more accurate positioning of the wafer with respect to the electron beam or optical mark before writing the pattern. After drying the resist, the spinner top is removed and the wafer is ready for the next processing step. Figure 6 shows the wafer 72 having the resist coated on the central portion 100 while the protected ring edge portion 102 is free of resist and, therefore, can be used directly as an electrical ground for the wafer top surface during electron beam exposure, electroplating, or more accurate registration if registration marks are contained within ring edge portion 102.

## Claims

1. A method of spin coating resist onto a wafer, the method incorporating the steps of mounting the wafer (72) onto a spinning head (10) incorporating a rotatable wafer platform (62), spinning the wafer (72) by means of the platform (62) and applying the resist onto the wafer (72), characterised in that the wafer (72) is clamped onto the platform (62) by means of a plate (78) which is tapered into a knife edge (86) at the wafer surface to seal the top of the wafer (72) in contact with the plate (78) and to allow the resist to flow up over the clamping plate (78) and off the spinning head (10).

2. A spinning head (10) for spin coating resist onto a wafer (72), the head incorporating a base (12) to be driven by a spin motor shaft (14), and a wafer platform (62) mounted on the base (12) to receive a wafer (72) to be spin coated, characterised in that the wafer platform (62) has a clamp plate (78) to clamp a wafer (72) to be coated onto the platform (62), the clamp plate (78) having a flat lower surface to engage and seal off a portion of a wafer (72) to be coated and an upper surface tapered to meet the lower surface at a knife edge (86) to allow resist to flow up over the clamp plate (78) and off the head (10).

3. A spinning head according to claim 2, wherein the clamp plate (78) is of circular ring configuration.

4. A spinning head according to claim 2 or 3, wherein the clamp plate (78) has means (76) for attachment to the base and the wafer platform is supported by a spring and ball joint interposed between the wafer platform and the base to enable the wafer platform to be depressed and to swivel relative to the base to accommodate a wafer between the clamp plate and the wafer platform.

## Revendications

1. Procédé d'application centrifuge de matériau photorésistant sur une pastille comprenant des étapes de montage de la pastille (72) sur une tête tournante (10) comportant une plate-forme porte-pastille rotative (62), d'entraînement de la pastille (72) en rotation au moyen de la plate-forme (62) et d'application du matériau photorésistant sur la pastille (62), caractérisé en ce que: la pastille (72) est bloquée sur la plate-forme (62) au moyen d'une plaque (72) dont l'épaisseur décroît jusqu'à un bord mince (86) à la surface de la pastille pour joindre le haut de la pastille (72) à la plaque (78) et permettre au matériau photorésistant de s'écouler par dessus la plaque de fixation (78) et dégager la tête tournante (10).

2. Tête tournante (10) pour application centrifuge de matériau photorésistant sur une pastille (72), la tête comportant une embase (12) entraînée par un arbre de moteur rotatif (14) et une plate-forme porte-pastille (62) montée sur l'embase (12) pour recevoir une pastille (72) à revêtir par application centrifuge, caractérisé en ce que: la plate-forme porte-pastille (62) comporte une plaque de fixation (78) qui bloque une pastille (72) à revêtir sur la plate-forme (62), la plaque de fixation (78) présentant une surface inférieure plate portant contre et isolant une partie d'une pastille (72) à revêtir et une surface supérieure dont l'épaisseur décroît pour former un bord mince (86) à la surface inférieure, permettant au matériau photo-résistant de s'écouler par dessus la plaque de fixation (78) et de dégager la tête (10).

3. Tête tournante selon la revendication 2, caractérisée en ce que la plaque de fixation (78) présente une configuration circulaire en anneau.

4. Tête tournante selon la revendication 2 ou 3 caractérisée en ce que la plaque de fixation (78) comporte des moyens (76) pour la fixation à l'embase et en ce que la plate-forme porte-pastille est portée par une rotule à ressort placée entre la plate-forme porte-pastille et l'embase pour permettre à la plate-forme porte-pastille d'être enfoncée et de pivoter par rapport à l'embase pour recevoir une pastille entre la plaque de fixation et la plate-forme porte-pastille.

**Patentansprüche**

1. Zentrifugalbeschichtungsverfahren zum Aufbringen einer Photolacklösung auf ein Halbleitersubstrat, bei dem das Halbleitersubstrat (72) auf der drehbaren Auflagescheibe (62) eines Trägerkopfes (10) aufliegt und unter Zufuhr der Photolacklösung mit dieser umläuft, dadurch gekennzeichnet, daß das Halbleitersubstrat (72) auf der Auflagescheibe (62) mittels einer Deckplatte (72) mit einer an der Unterseite ihrer Innenfläche befindlichen Schneide (86) festgehalten wird, welche die durch die Deckplatte (78) abgedeckte Fläche des Halbleitersubstrats (72) abdichtet und die Lösung über die Oberfläche der Deckplatte (78) nach außen ablenkt.

2. Vorrichtung zum Aufbringen einer Photolacklösung auf ein Halbleitersubstrat, mit einem Trägerkopf (10) mit durch eine Motorwelle (14) umlaufend angetriebener Grundplatte (12) und einer auf der Grundplatte (12) montierten Auflagescheibe (62) zur Aufnahme des zu beschichtenden Halbleitersubstrats (72), dadurch gekennzeichnet, daß auf der Auflagescheibe (62) eine Deckplatte (78) zur Halterung des Halbleitersubstrats (72) aufliegt, welche eine untere Fläche zur Auflage auf dem Halbleitersubstrat (72) und zum Abdichten von dessen abgedecktem Flächenbereich aufweist sowie eine konisch geformte obere Fläche, welche zur unteren Fläche eine Schneide (86) bildet und das Abfließen der Lösung über die obere Fläche der Deckplatte (78) nach außen bewirkt.

3. Vorrichtung nach Anspruch 2, dadurch gekennzeichnet, daß die Deckplatte (78) als kreisrunder Ring ausgebildet ist.

4. Vorrichtung nach den Ansprüchen 2 und 3, dadurch gekennzeichnet, daß zur Befestigung der Deckplatte (78) auf der Grundplatte ein Haltering (76) angeordnet ist und daß die Auflagescheibe (62) für das Halbleitersubstrat (72) mittels einer Feder-Kugel-Verbindung (44, 58) auf der Grundplatte (12) geführt ist, so daß die Auflagescheibe (62) federnd nachgiebig und schwenkbar auf der Grundplatte (12) gelagert ist.

FIG. 2

FIG. I

FIG.4

72

74

62

66

68

64

58

56

55

70

52

50

44

42

41

54

46

48

FIG.3

40

58

64

72

74

70

71

71

66

68

56

55

62

44

48

52

50

46

41

42

40

**0 000 262**

FIG. 5

FIG. 6